# EUROPÄISCHE PATENTSCHRIFT

(11) **EP 0 569 417 B1**
(45) Veröffentlichungstag und Bekanntmachung des Hinweises auf die Patenterteilung: **05.07.1995**
(21) Anmeldenummer: 92903497.3
(22) Anmeldetag: 28.01.1992
(51) Int. Cl.: G06K 19/077

(54) **VERFAHREN ZUR HERSTELLUNG EINER TRAGBAREN DATENTRÄGERANORDNUNG**
PROCESS FOR MAKING A PORTABLE DATA SUPPORT
PROCEDE POUR FABRIQUER UN SUPPORT DE DONNEES PORTABLE

(30) Priorität: 28.01.1991 DE 4102435; 28.01.1991 DE 4102437
(43) Veröffentlichungstag der Anmeldung: 18.11.1993
(73) Patentinhaber: SIEMENS AKTIENGESELLSCHAFT, 80333 München (DE)
(72) Erfinder: MELBERT, Joachim, D-8024 Deisenhofen (DE)
(86) Internationale Anmeldenummer: DE9200050
(87) Internationale Veröffentlichungsnummer: WO9213320

(56) Entgegenhaltungen:
- EP-A- 0 287 843
- WO-A-88/08592
- DE-A- 3 624 852
- DE-A- 3 901 402
- DE-C- 3 935 364
- DE-U- 8 913 326
- DE-U- 8 913 327
- ELEKTRONIK. Bd. 38, Nr. 25, 8. Dezember 1989, MUNCHEN DE Seiten 66 - 78; SICKERT UND WEINERTH: 'Schlüsseltechnologie Microelektronik'

## Beschreibung

Die Erfindung betrifft ein Verfahren zur Herstellung einer tragbaren Datenträgeranordnung nach dem Oberbegriff des Patentanspruches 1 bzw. nach dem Oberbegriff des Patentanspruches 2. Solche Datenträgeranordnungen sind unter anderem in Form von sogenannten Chipkarten oder als Kopf (Griff) eines Schlüssels bekannt, u.a. von der DE-U-8913327.

Die bekannten Chipkarten bestehen üblicherweise aus einem Modul und einem Kartenrohling, der eine Öffnung oder eine flächige Vertiefung aufweist, in die das Modul eingebracht ist. Das Modul besteht aus einem Trägerband aus Glas/Epoxi-Material, aus laminiertem Epoxid oder aus Polyester, das mit einer Kupferfolie laminiert ist, die auf der dem Trägerband zugewendeten Seite mit galvanisch aufgebrachtem Nickel und auf der anderen Seite mit Gold veredelt ist. Die Kupferfolie bildet metallische Kontakte, deren mit Gold veredelte Seite bei einer gebrauchsfertigen Karte an einer Oberfläche der Karte angeordnet sind. Das Trägerband enthält bei manchen Modulen eine Öffnung, in die mit einem Chipkleber (bei CMOS-Chips bevorzugt einem Silberleitkleber, bei NMOS-Chips mit einem Isolierkleber) ein integrierter Schaltkreis auf die Kupferfolie geklebt ist und weitere Öffnungen, durch die die einzelnen metallischen Kontakte über eine Aluminium- oder Goldbondung mit auf dem integrierten Schaltkreis befindlichen Anschlußpads verbunden ist. Auf den integrierten Schaltkreis und die Kontaktierung ist eine Abdeckung aus Silikon-Kautschuk oder Epoxidharz aufgebracht.

Es sind auch solche Karten bekannt, bei denen innerhalb des Moduls die Anschlußpads mit den metallischen Kontakten nicht durch Drahtbondung verbunden sind.

Die FR 26 01 477 B1 beschreibt ein Modul, bei dem in den Öffnungen des Trägermaterials jeweils ein plastisch verformbares elektrisch leitfähiges Material eingebracht ist, in das jeweils die Anschlußpads des integrierten Schaltkreises unmittelbar eingedrückt sind und das außerdem eine Verbindung zu den metallischen Kontakten herstellt.

Aus der EP 0 207 852 AI ist eine Karte mit einem solchen Modul bekannt, bei dem die die metallischen Kontakte bildende Folie im Bereich der Öffnungen in dem Trägermaterial jeweils eine Prägung aufweist und somit jeweils in diese Öffnung hineinragt und unmittelbar mit den Anschlußpads eines integrierten Schaltkreises, beispielsweise durch Thermokompression, verbunden ist.

Die US-A-4,774,633 beschreibt eine Karte mit einem solchen Modul, bei dem die Öffnungen in dem Trägermaterial mit Lotmasse ausgefüllt sind, die die Anschlußpads eines integrierten Schaltkreises unmittelbar mit den metallischen Kontakten verbindet.

Die US-A-4,222,516 und die US-A-4,216,577 beschreiben Karten mit eingebauten Modulen, wobei jeweils auf dem Trägermaterial des Moduls metallische Leiterbahnen aufgebracht sind, die jeweils eine Anschlußstelle im Bereich eines Anschlußpads des unmittelbar damit verbundenen integrierten Schaltkreises angeordnet haben und deren andere Anschlußstelle geometrisch so angeordnet ist, daß mit Hilfe einer Durchkontaktierung durch das Trägermaterial metallische Kontakte auf der anderen Seite des Trägermaterials gebildet werden. Außerdem wird eine Ausführungsform gezeigt, bei der diese Durchkontaktierung nicht durch das Trägerband sondern durch das Kartenmaterial vorgenommen wird. Bei solchen in der US-A-4,222,516 bzw. US-A-4,216,577 beschriebenen Kunststoffkörpern, speziell Chipkarten, ist die an der Oberfläche des Kunststoffkörpers zugängliche Kontaktfläche entweder sehr klein oder es ist ein unverhältnismäßig großes Metallvolumen zum Herstellen größerer Kontaktflächen erforderlich, wobei zusätzlich aufgrund großer Öffnungen die Stabilität der Gesamtanordnung einer solchen Chipkarte ungünstig beeinflußt wird. Chipkarten mit kleinen Kontaktflächen haben sich jedoch wegen der dadurch zu geringen Toleranz bei der Anordnung der Kontakte von zu kontaktierenden stationären Einheiten als ungünstig erwiesen.

Die DE 30 46 192 C2 bzw. US-A-4,549,247 befaßt sich mit einem Modul für eine Chipkarte und beschreibt eine spezielle Anordnung metallischer Leiter, die einen Halbleiterbaustein mit elektrischen Kontakten verbinden.

Die DE 31 31 216 C2 bzw. US-A-4,463,971 beschreibt eine Ausweiskarte mit IC-Baustein und befaßt sich vornehmlich mit der Verankerung eines Moduls dieser Ausweiskarte.

Die DE 31 51 408 C1 bzw. US-A-4,603,249 beschreibt eine Ausweiskarte mit auf einem Modul angeordnetem IC-Baustein in einem Hohlraum, die aufgrund eines aufwendigen Verfahrens eine ebene Oberfläche aufweist.

Aus dem deutschen Gebrauchsmuster DE-U-87 16 548 ist eine Karte mit integrierten Halbleiterchips bekannt, die unabhängig von der Lage der Karte in einer stationären Einheit (Lesegerät) eine Auswertung der Karte durch Energie- und bidirektionelle Datenübertragung ermöglicht. Die Energie- und Datenübertragung geschieht bei dieser Karte nicht über metallische Kontakte, sondern über elektromagnetische Felder, deren magnetische Feldlinien senkrecht zur Kartenoberfläche verlaufen und die in mindestens zwei in der Karte auf einem Träger integrierten flächigen Spulen ausgewertet und beeinflußt werden. Ein entsprechendes Verfahren wird unter anderem in der DE 34 47 560 C2 näher beschrieben.

Bei mehreren Spulen als Koppelelemente bzw. mehreren elektromagnetischen Feldern auf engem Raum ist hierbei darauf zu achten, daß diese sich möglichst nicht gegenseitig beeinflussen. Noch wichtiger wird eine exakte Positionierung der Spulen in der Chipkarte sowie eine exakte Positionierung der Erregerspulen der elektromagnetischen Felder in einer stationären Einheit, wenn auf der entsprechenden Chipkarte außerdem ein Magnetstreifen vorgesehen ist. Hierbei ist zu beachten, daß dann, wenn eine Prägezone auf einer Chipkarte vorgesehen ist, die flächigen Spulen nicht im Bereich der Prägezone angebracht werden dürfen, da sie durch eine Prägung entweder zerstört oder in ihrem induktiven Verhalten beeinflußt würden.

In der DE 37 21 822 C1 ist eine Chipkarte beschrieben, bei der eine metallische flächenförmige Induktivität auf dem Halbleiterkörper eines integrierten Schaltkreises angeordnet ist, dieser Halbleiterkörper auf einem Träger angeordnet ist und dieser Träger in einen Kunststoffkörper eingebracht ist. Dieses Verfahren ist jedoch teuer und dann, wenn mehrere Induktivitäten benötigt werden, nicht praktikabel.

In dem Artikel "Schließen mit Intelligenz - Elektronik machts möglich" aus der Zeitschrift baubeschlag-magazin 5/88, S. 76 bis 78 werden Schlüssel beschrieben, in deren Reide sich jeweils eine elektronische Schaltung befindet. Der Artikel "Der Zündschlüssel als Steckbrief' von J. Lewandowski aus Süddeutsche Zeitung Nr. 163, 18. Juli 1990, S. 33, zeigt einen solchen Schlüssel, zwischen dessen Griffschalen sich ein Modul mit einer integrierten Schaltung und zwei Drahtspulen zur Energie- und Datenübertragung befinden.

Die beschriebenen tragbaren Datenträgeranordnungen, bestehend aus einem Modul und einem Kunststoffkörper, werden üblicherweise nach folgendem Verfahren hergestellt:
A) Die flächigen metallischen Koppelelemente werden auf ein Trägermaterial, z.B. einen Film, aufgebracht. Hierzu wird eine Metallfolie durch ein Stanz- oder ein Ätzverfahren in die für die Koppelelemente erforderliche Form gebracht und entweder bevor oder nachdem die Metallfolie ihre gewünschte Form hat, wird sie durch Kleben oder durch Herstellen einer mechanischen Befestigung auf dem Trägermaterial befestigt.
B) Die integrierte Schaltung wird auf das Trägermaterial aufgebracht. Dies kann durch Kleben der integrierten Schaltung auf den Film oder auf die Metallfolie erfolgen. Außerdem kann bei Verwendung der sogenannten Flip-Chiptechnik die integrierte Schaltung mit ihren Anschlußpads elektrisch leitend unmittelbar an elektrischen Leitern befestigt werden, die mit den metallischen Koppelelementen elektrisch leitend verbunden sind. Die Anschlußpads können hierbei beispielsweise mit Hilfe von Leitkleber oder durch Löten befestigt werden.
C) Wenn bei Schritt B) keine Flip-Chipmethode verwendet wird, werden die auf dem Trägermaterial angeordneten metallischen Koppelelemente - beispielsweise durch Drahtbonden - elektrisch leitend mit Anschlüssen der integrierten Schaltung verbunden.
D) Die integrierte Schaltung und die Verbindung zwischen der integrierten Schaltung und den metallischen Koppelelementen werden mit einer Abdeckung, beispielsweise Silikon-Kautschuk oder einem Kunststoff wie Epoxidharz versehen.
E) Das in den Verfahrensschritten A) bis D) hergestellte Modul wird in einen flachen Kunststoffkörper eingebaut.

Dieser relativ aufwendige Verfahrensschritt E), der üblicherweise auch das Abtrennen der einzelnen Module von einem Film oder von einem Modulstreifen mit einer Vielzahl gleicher Module umfaßt, kann beispielsweise das Einklipsen eines Moduls in eine entsprechende Öffnung eines Kunststoffkörpers beinhalten oder das Einkleben eines Modules in eine Vertiefung eines Kunststoffkörpers. Außerdem kann ein Modul in einem Verbund aus Kunststoffolien durch Heißkaschieren angebracht werden. Wenn der Kunststoffkörper vor dem Einbringen des Moduls eine Öffnung aufweist, ist üblicherweise auch noch eine weitere Abdeckung zum vollständigen Schließen bzw. Auffüllen dieser Öffnung erforderlich. Wenn die einzelnen Module nach Abschluß der Verfahrensschritte A) bis D) auf einem Filmband angebracht sind, ist üblicherweise ein Werkzeug erforderlich, das nicht nur das einzelne Modul in seiner linearen Bewegung zu einem Kunststoffkörper transportiert, sondern dieses Werkzeug muß auch noch eine Drehung um 90° vornehmen.

Wenn bei einem Verfahren zur Herstellung eines tragbaren Datenträgers nach Abschluß der Verfahrensschritte A) bis D) die Module auf einem Filmband angeordnet sind, so kann nach Beendigung der Herstellung des Datenträgers der Abfallanteil der Trägerfolie des Modulfilmes und auch der Metallfolie zur Herstellung der Koppelelemente sehr groß sein.

Untersuchungen an einer Vielzahl von solchen bekannten, in Massenfabrikation hergestellten Karten haben ergeben, daß die Positionierung derflächigen metallischen Kontakte einer relativ großen Streuung unterliegt, so daß einerseits die Ausschußrate relativ hoch ist und andererseits hohe Anforderungen an die Präzision der mit diesen Karten kommunizierenden stationären Einheiten gestellt werden.

Die Abweichungen der Kontaktanordnungen von gleichen Karten liegen hierbei je nach Herstellungsverfahren entweder im Abstand zu den Bezugskanten der Karte oder es liegt eine leichte Verdrehung des Moduls und somit der Kontakte vor. Außerdem können Abweichungen in Längsrichtung sowie Verdrehungen bei der gleichen Karte vorliegen.

Außerdem kann die Maßhaltigkeit bekannter Chipkarten bezüglich der Dicke im Bereich des integrierten Schaltkreises bzw. des Moduls einer gewissen Streuung unterworfen sein, wobei (teilweise trotz vorherigem Abschleifen der Abdeckung des Moduls) sowohl Überstände, als auch Abschrägungen sowohl an einer als auch an beiden Oberflächen der Karte auftreten können.

Ein weiteres Problem bekannter Kunststoffkörper mit IC, die aus einem einen integrierten Schaltkreis und Koppelelemente enthaltenden Modul und einem Kunststoffteil bestehen, liegt darin, daß bei fertigmontierten Kunststoffkörpern das Modul aus dem Kunststoffteil herausspringen kann.

Wenn das Modul als Trägermaterial ein Epoxiband aufweist, besteht ein weiteres Problem darin, diese Trägersubstanz in das übrige Kartenmaterial einzukleben. Eine gute Klebeverbindung zwischen einem Epoximaterial und dem beispielsweise üblicherweise für das Substrat von Chipkarten verwendeten Kunststoff ist sehr aufwendig, da übliche Kleber entweder nur für Epoximaterial oder nur für Substratkunststoff eine entsprechend hohe Adhäsion aufweisen.

Die DE 39 01 402 AI beschreibt ein Verfahren zur Herstellung einer Chipkarte derart, daß zunächst ein Kunststoffkörper mit auf einer Flächenseite befindlicherWanne hergestelltwird. Anschließend werden innerhalb der Wanne Leiterbahnen und auf der gegenüber der Wanne angeordneten Oberfläche Kontaktflächen aufgebracht und diese mittels einer Durchkontaktierung miteinander elektrisch verbunden. Nach dem Einsetzen eines integrierten Schaltkreises in die Wanne erfolgt die elektrische Verbindung zwischen diesem und den Leiterbahnen über Bonddrähte. Nach Verfüllen der Räume zwischen dem integrierten Schaltkreis und der Wanne durch eine Vergußmasse werden auf der Ober- und Unterseite des Kunststoffkörpers Abdeckfolien aufgebracht.

Die DE 29 20 012 B1 beschreibt insbesondere in Spalte 4, Zeile 68 und in Spalte 5, Zeilen 1 bis 20 ein Verfahren zur Herstellung eines Trägerelementes einer Datenträgeranordnung, wobei eine Folie beidseitig mit Kupfer beschichtet wird. Daraufhin werden auf der Vorderseite dieser Folie Kontaktflächen und auf der Rückseite Leiterbahnen für den IC-Baustein ausgeätzt. Kontaktflächen und Leiterbahnen werden schließlich in Durchkontaktier-Verfahren miteinander verbunden.

Die DE 39 35 364 C1 beschreibt eine Chipkarte, bei der als Koppelelemente zum Übertragen von Daten bzw. Signalen sowohl ohmsche Kontakte als auch Induktivitäten vorgesehen sind.

Insbesondere zum Herstellen solcher tragbarer Datenträgeranordnungen mit präzise angeordneten flächigen metallischen Koppelelementen in Form von Kontakten und Induktivitäten ist der Herstellungsaufwand sehr groß.

Aufgabe der Erfindung ist das Bereitstellen eines Verfahrens zur Herstellung einer tragbaren Datenträgeranordnung wie zum Beispiel einer Chipkarte oder eines Schlüssels nach dem Oberbegriff des Patentanspruchs 1 bzw. des Patentanspruches 2, das eine präzise Kontaktflächenaufbringung in weniger aufwendiger Weise ermöglicht.

Diese Aufgabe wird gelöst durch ein Verfahren mit den Merkmalen des Patentanspruches 1 beziehungsweise ein Verfahren mit den Merkmalen des Patentanspruches 2. Günstige Ausgestaltungsformen der Erfindung sind Gegenstand der Unteransprüche.

Im wesentlichen liegt die Erfindung darin, daß gegebenenfalls flächige metallische ohmsche Koppelelemente unmittelbar auf der einen flächigen Oberfläche des Kunststoffkörpers aufgebracht werden, daß Anschlußkontakte sowie Induktivitäten als Koppelelemente auf der Oberfläche des Kunststoffkörpers im Bereich der Vertiefung angebracht werden und gegebenenfalls im gleichen Arbeitsgang eine elektrische Durchkontaktierung vorgenommen wird.

Der den Datenträger bildende Kunststoffkörper ist also gleichzeitig der Träger für den integrierten Schaltkreis und für die Koppelelemente sowie deren Anschlußkontakte. Dieser Kunststoffkörper kann ein Chipkartenrohling miteinerflächigen Vertiefung sein, auf denen noch durch heißkaschieren oder laminieren auf einer oder zwei Oberflächen weitere Folien aufgebracht werden. Ebenso kann es sich bei dem Kunststoffkörper um einen Chipkartenrohling mitflächiger Vertiefung handeln, auf den lediglich noch die metallischen flächigen Koppelelemente aufgebracht werden, in den mindestens ein integrierter Schaltkreis eingebracht und kontaktiert wird und bei dem dann die flächige Vertiefung mit Abdeckmasse, z.B. Epoxidharz oder Schutzlack aufgefüllt wird. Ebenso kann es sich bei dem Substrat um einen Teil eines Schlüsselkopfes handeln, in den ein üblicherweise metallischer Bart eingebracht wird und der, nachdem flächige metallische Koppelelemente aufgebracht worden sind und ein oder mehrere integrierte Schaltkreise kontaktiert worden sind entweder nur mit einer Abdeckung versehen werden, oder durch einen weiteren Teil in Form eines Deckels verschlossen wird.

Als Verfahrensschritt a in Patentanspruch 1 können die flächigen metallischen Koppelelemente entweder durch Aufdampfen, durch ein Aufstäubverfahren, sogenanntes Sputtern oder durch stromlose Abscheidung aufgebracht werden. Hierbei führt die höhere Oberflächenrauhigkeit bei abgeschiedenen Metallschichten zu einer günstigeren Verbindung zwischen Metall und Kunststoff. Um im Verfahrensschritt c des Patentanspruchs 1 eine gute Bondung zu erreichen ist jedoch empfehlenswert, zumindest bei abgeschiedenen Metallen mit größerer Oberflächenrauhigkeit im Bondbereich eine Veredelung, z.B. mit Nickel, vorzunehmen. Die Veredelung kann durch galvanische Abscheidung erfolgen.

Bei nach erfindungsgemäßen Verfahren hergestellten Datenträgeranordnungen kann der Metallüberzug, der die flächigen metallischen Koppelelemente bildet, in Form einer geschlossenen Fläche aufgetragen werden und dann durch partielles Entfernen von Metall, z.B. durch Ätzen, in die gewünschte Form gebracht werden. Ein solches Vorgehen bietet sich bei aufgedampfen oder aufgestäubten Koppelelementen an. Werden die flächigen metallischen Koppelelemente außenstromlos abgeschieden, eventuell nach vorherigem Bekeimen des Substrates, so kann die Struktur der metallischen Koppelelemente durch gezieltes Aufbringen des Metalles festgelegt werden. Zur Realisierung einer Metallisierung des Substrates an beiden Hauptoberflächen eines flachen Kunststoffkörpers, z.B. an einer Hauptoberfläche und der Oberfläche einer auf der anderen, gegenüberliegenden Hauptoberfläche des Kunststoffkörpers angebrachten flächigen Vertiefung, sowie der gleichzeitigen Durchkontaktierung bietet sich besonders eine außenstromlose Abscheidung an, wobei diese Metallisierung im gleichen Arbeitsgang des Verfahrens schrittweise vorgenommen werden. Geeignete Verfahren zum außenstromlosen Aufbringen von Metallisierungen auf ein Substrat aus Kunststoff werden insbesondere in der EP 0 361 195 A2 (US-Serial No. 406,551), der EP 0 361 193 A2 (US-Serial No. 388,818), der EP 0182193 A3 (US-A-4,574,095), der EP 0 287 843 B1 (US-Serial No. 176,325), der EP 0 180 101 A2 (US-Serial No. 667,241), der EP 0 370 133 AI und der US-A-4,608, 274 beschrieben und müssen daher hier nicht näher behandelt werden. Besonders günstig ist hierbei die Verwendung eines Laser-Ablations-Verfahren, wie z.B. in der EP 0 287 843 B1 beschrieben. Mit den beschriebenen Verfahren lassen sich sowohl zweidimensionale als auch dreidimensionale Metallstrukturen auf Kunststoffsubstrate aufbringen, wobei die Metallstrukturen wahlweise in das Substrat hineinragen oder erhaben auf das Substrat aufgebracht werden können.

Bei Ausführungsformen von nach einem erfindungsgemäßen Verfahren hergestellten tragbaren Datenträgeranordnungen mit flächiger Vertiefung zur Aufnahme eines oder mehrerer integrierter Schaltkreise, die als Koppelelemente flächige metallische Kontakte an einer der Hauptoberflächen aufweisen, befindet sich die flächige Vertiefung im Bereich der anderen, den metallischen Kontakten gegenüberliegenden Hauptoberfläche des flachen Kunststoffkörpers. Zwischen den flächigen metallischen Kontakten und in der flächigen Vertiefung befindlichen metallischen Anschlüssen ist durch Öffnungen im Kunststoffkörper jeweils eine elektrische Verbindung vorgenommen. Die metallischen Induktivitäten haben auch Anschlüsse und sind mit diesen im Bereich der flächigen Vertiefung auf der Oberfläche des Kunststoffkörpers angebracht. Die metallischen Kontakte sind jeweils in bekannterweise, beispielsweise durch Drahtbondung, durch Kleben oder durch unmittelbare Lötverbindung mit Anschlußpads des bzw. der integrierten Schaltkreise in der flächigen Vertiefung verbunden.

Da die flächige Vertiefung an der den gegebenenfalls vorhandenen (Patentanspruch 2) Kontaktflächen abgewandten Hautoberfläche des flachen Kunststoffkörpers angeordnet ist, ist eine besonders wirtschaftlich herstellbare Ausführungsform einer tragbaren Datenträgeranordnung dadurch realisierbar, daß die flächige Vertiefung nach Montage des integrierten Schaltkreises lediglich mit einer Abdeckung aufgefüllt wird. Um mechanischen Druck von dem elektronischen Schaltkreis fern zu halten, kann diese Abdeckung als eine erste Schicht aus nach Aushärtung weichem Abdeckmaterial und eine zweite Schicht aus mechanisch stabil aushärtenden Abdeckmaterial eingebracht werden. Als Abdeckung kann unter anderem ein thermisch härtbares Material wie Epoxid oder Schutzlack oder ein entsprechendes durch UV-Licht härtbares Material verwendet werden.

Das großflächige flache Auftragen von Abdeckmasse ist unter anderem in der europäischen Patentanmeldung Nr. 90110609.6 (US- Serial No. 533,387) beschrieben.

Ein Vorteil erfindungsgemäßer Verfahren ist dadurch gegeben, daß kein Zwischenträger zum Aufnehmen des integrierten Schaltkreises und der Koppelelemente erforderlich ist und daß dadurch außerdem der aufwendige Verfahrensschritt des Einbringens dieses Zwischenträgers in den Kunststoffkörper der tragbaren Datenträgeranordnung nicht erforderlich ist. Ein weiterer Vorteil liegt im Einsparen des Verfahrensschrittes zur Durchkontaktierung der beiden flächigen Metallisierungen.

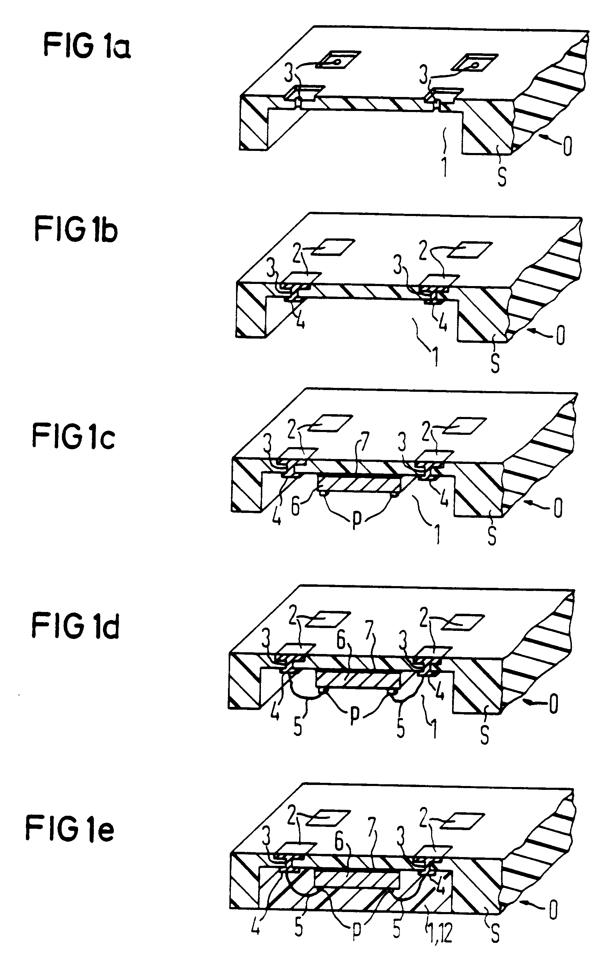

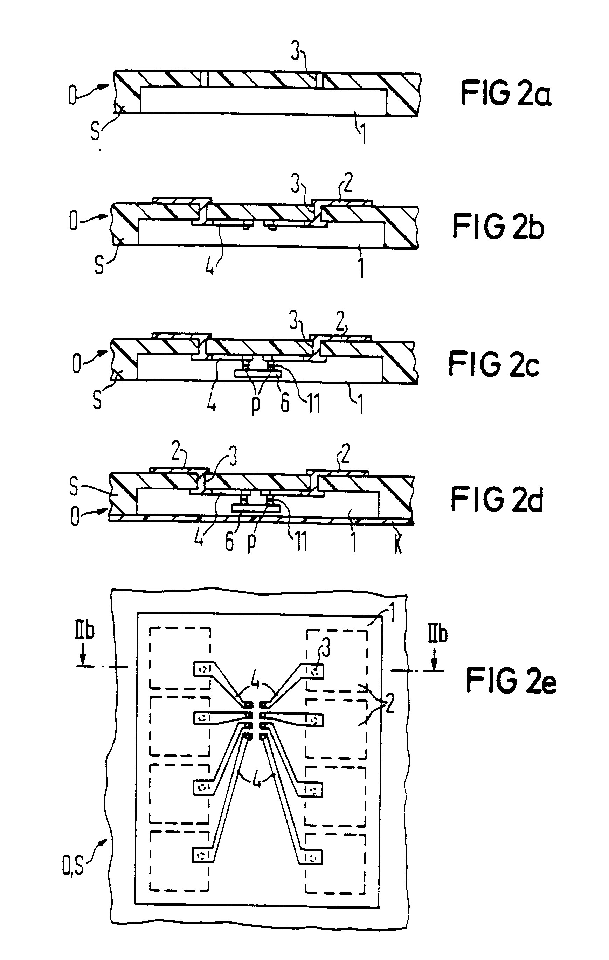

Nachfolgend wird die Erfindung anhand von in den Figuren dargestellten Ausführungsbeispielen näher erläutert, wobei von jedem gezeigten Ausführungsbeispiel eine Darstellung des Teilproduktes jeweils vor und nach jedem Verfahrensschritt des kennzeichnenden Teiles der Patentansprüche dargelegt wird. Die Figuren 1 und 2 zeigen hierbei Chipkarten mit flächigen Kontakten an der der Vertiefung gegenüberliegenden Oberfläche des Kunststoffkörpers mit einer Durchkontaktierung. Die vorliegende Erfindung ist aber auch denkbar für ausschließlich flächige metallische Induktivitäten an der Oberfläche der Karte innerhalb der Vertiefung und mit diesen Induktivitäten verbundene Anschlüsse, wie sie in den Figuren mit dem Bezugszeichen 4 gekennzeichnet ist. Es zeigt die Figur 1 als Ausführungsbeispiel in Schnittdarstellung eine tragbare, flache Datenträgeranordnung 0, und zwar
Figur 1a vor der Durchführung des Verfahrensschrittes a aus Patentanspruch 1,
Figur 1 ein Zwischenprodukt nach dem Verfahrensschritt a des kennzeichnenden Teiles des Patentanspruches 1,
Figur 1c das Zwischenprodukt nach dem Verfahrensschritt b des Patentanspruches 1,
Figur 1d das Zwischenprodukt dieses besonderen Ausführungsbeispieles nach der Durchführung des Verfahrensschrittes c dieses Patentanspruches und Figur le das Endprodukt eines erfindungsgemäßen Verfahrens nach Durchführung einer möglichen Ausführungsform des Verfahrensschrittes d des Patentanspruches 1.

Die Figur 2 als anderes Ausführungsbeispiel zeigt in Figur 2e einen Teilausschn itt der eine flächige Vertiefung 1 aufweisenden Hauptoberfläche eines Zwischenproduktes einer tragbaren Datenträgeranordnung 0 nach der Durchführung des Verfahrensschrittes a des Patentanspruches 1 und gibt eine Schnittlinie Ilb-Ilb an.

Die Figuren 2a bis 2d zeigen die Teil- bzw. Zwischenprodukte dieses Ausführungsbeispieles vor bzw. nach jedem im kennzeichnenden Teil des Patentanspruches 1 beschriebenen Verfahrensschritt. Hierbei zeigt Figur 2a als Teilansicht eine Schnittdarstellung durch einen flachen Kunststoffkörper S, bevor der Verfahrensschritt a aus Patentanspruch 1 durchgeführt wird;
Figur 2b die entsprechende Schnittdarstellung nachdem ein Verfahrensschritt a aus Patentanspruch 1 durchgeführtwurden, also einen Schnitt durch den in Figur 2e dargestellten Gegenstand;
Figur 2c die entsprechende Schnittdarstellung nachdem Verfahrensschritte b und c nach Patentanspruch 1 durchgeführt wurden, wobei zu erkennen ist, daß der integrierte Schaltkreis 6 in dem in Figur gezeigten Ausführungsbeispiel mit Hilfe der sogenannten Flip-Chip-Montagetechnik eingebaut wurde und
Figur 2d zeigt die gleiche Schnittansicht durch einen tragbaren flachen Kunststoffkörper, nachdem der Verfahrensschritt d des Patentanspruches 1 derart durchgeführt wurde, wie er in Patentanspruch 8 beschrieben ist.

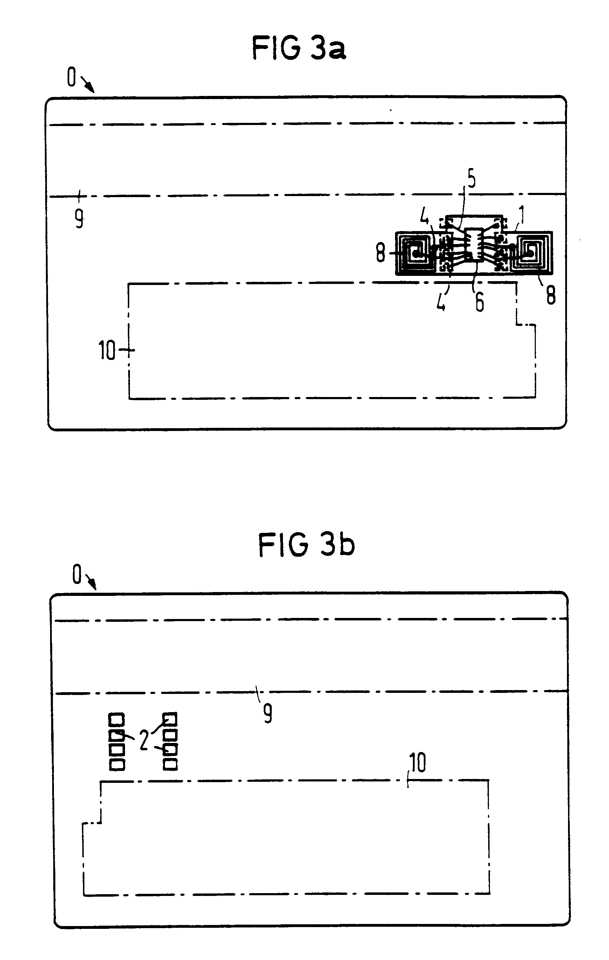

Es zeigen die Figuren 3a und 3b als besonderes Ausführungsbeispiel eines flachen, tragbaren Kunststoffkörpers 0 die beiden Hauptoberflächen einer erfindungsgemäßen Chipkarte, die als metallische Koppelelemente sowohl metallische Kontakte 2 als auch metallische Induktivitäten 8 aufweist, wobei die metallischen Kontakte 2 nach den Vorschriften der ISO 7816 angeordnet sind und außerdem sowohl eine Prägezone 10 als auch eine Magnetstreifenzone 9 entsprechend der Norm vorgesehen sind.

Figur 1 zeigt in perspektivischer Schnittdarstellung eine Teilansicht einer tragbaren Datenträgeranordnung 0, bestehend aus einem Kunststoffkörper S mit einer flächigen Vertiefung 1 an einer der Hauptoberflächen des Kunststoffkörpers S und mit flächigen metallischen Kontakten 2 an der gegenüberliegenden Hauptoberfläche des Kunststoffkörpers S. Der Kunststoffkörper S weist im Bereich der flächigen Vertiefung 1 und der metallischen Kontakte 2 Öffnungen 3 auf, durch die jeweils eine elektrisch leitfähige Verbindung zwischen den metallischen Kontakten 2 und in derflächigen Vertiefung 1 angeordneten metallischen Anschlüssen 4 vorgenommen ist. Die metallischen Kontakte 2, die Durchkontaktierung und auch die metallischen Anschlüsse 4 können unter anderem nach einem in der EP-0 361193 A2 und der EP 0 361 195 A2 beschriebenen Verfahren hergestellt worden sein.

Die Oberflächen der in dem Ausführungsbeispiel nach Figur 1 dargestellten metallischen Kontakte 2 bilden mit der Oberfläche des flachen tragbaren Kunststoffkörpers 0, in die sie integriert sind, eine Ebene und ragen in den tragbaren flachen Kunststoffkörper 0 bzw. das Substrat S hinein.

In derflächigen Vertiefung 1 des Substrates S ist ein integrierter Schaltkreis 6 angeordnet und über Befestigungsmittel 7, beispielsweise über einen Kleber, unmittelbar an dem Substrat S in der flächigen Vertiefung befestigt. Der integrierte Schaltkreis 6 weist Anschlußpads P auf, die in dem gezeigten Ausführungsbeispiel jeweils über einen Bonddraht 5 mit einem metallischen Anschluß 4 verbunden sind. Die flächige Vertiefung 1 ist mit einer Abdeckung 12 aufgefüllt.

Figur 1a zeigt einen Kunststoffkörper S mit einer flächigen Vertiefung 1, mit Öffnungen 3 im Bereich dieserflächigen Vertiefung 1 und mit Vertiefungen im Bereich dieser Öffnungen an der der flächigen Vertiefung 1 gegenüberliegenden Hauptoberfläche des Kunststoffkörpers S.

Figur 1 b zeigt den Gegenstand von Figur la nach Durchführung eines Verfahrensschrittes a und zeigt somit zusätzlich metallische Anschlüsse 4 im Bereich der flächigen Vertiefung 1 sowie von diesen metallischen Anschlüssen 4 ausgehende Durchkontaktierungen durch die Öffnungen 3 im Kunststoffkörperzu metallischen Kontakten 2 an der der flächigen Vertiefung gegenüberliegenden Hauptoberfläche des Kunststoffkörpers S.

Figur 1c zeigt den Gegenstand aus Figurlb nachdem ein Verfahrensschritt b nach den Patentansprüchen durchgeführt worden ist. Figur 1c zeigt somit zusätzlich der in flächigen Vertiefung 1 einen integrierten Schaltkreis 6 mit Anschlußpads P, der über Befestigungsmittel 7, beispielsweise einen Kleber, an dem Kunststoffkörper S befestigt ist.

Figur 1d zeigt den Gegenstand von Figur 1c, nachdem ein Verfahrensschritt c der Patentansprüche durchgeführt worden ist.

Figur 1d zeigt somit zusätzlich eine elektrisch leitende Verbindung zwischen den Anschlußpads P des integrierten Schaltkreises 6 und den metallischen Anschlüssen 4. In dem gezeigten Ausführungsbeispiel ist diese elektrisch leitende Verbindung durch Bonddrähte 5 realisiert.

Figur 1 zeigt den Gegenstand von Figur 1 d nach Durchführung eines Verfahrensschrittes d entsprechend den Patentansprüchen. Demgemäß ist die flächige Vertiefung 1 in Figur 1e mit Kunststoff 12 abgedeckt.

Figur 2e zeigt als besonderes Ausführungsbeispiel einen Ausschnitt einer tragbaren Datenträgeranordnung 0 mit einem Kunststoffkörper S speziell im Bereich einer flächigen Vertiefung 1.

In der in Figur 2e dargestellten flächigen Vertiefung 1 sind metallische Anschlüsse 4 dargestellt, die durch als verdeckte Kanten dargestellte Öffnungen 3 mit ebenfalls als verdeckte Kanten dargestellten flächigen metallischen Kontakten 2 elektrisch leitfähig verbunden sind. Die metallischen Kontakte 2 befinden sich hierbei an der gegenüberliegenden Hauptoberfläche der tragbaren Datenträgeranordnung 0. Die metallischen Anschlüsse 4 sind in Form von Leiterbahnen derart ausgebildet, daß, wie in Figur 2c und 2d gezeigt, ein integrierter Schaltkreis 6 derart in die flächige Vertiefung 1 des Kunststoffkörpers S eingebracht werden kann, daß jeder seiner Anschlußpads P im Bereich eines metallischen Anschlusses 4 angeordnet ist.

Figur 2d zeigt das Endprodukt des Ausführungsbeispiels von Figur 2 in Form einer Schnittdarstellung einer tragbaren Datenträgeranordnung 0, bestehend aus einem Kunststoffkörper S mit einer flächigen Vertiefung 1 an einer der Hauptoberflächen und mit an der gegenüberliegenden Hauptoberfläche angeordneten metallischen Kontakten 2. Die metallischen Kontakte 2 sind durch Öffnungen 3 im Kunststoffkörper S, die mit elektrisch leitfähigem Material aufgefüllt sind, mit metallischen Anschlüssen 4 in der flächigen Vertiefung 1 verbunden. In der flächigen Vertiefung 1 ist außerdem ein integrierter Schaltkreis 6 mit Anschlußpads P angeordnet, wobei die Anschlußpads Pjeweils über elektrisch leitendes Verbindungsmittel 11 an einen metallischen Anschluß 4 angeschlossen sind. Als elektrisch leitendes Verbindungsmittel 11 kann hierbei sowohl Lotmasse als auch elektrisch leitender Kleber vorgesehen sein. Auf die Hauptoberfläche des Kunststoffkörpers S, an der sich die flächige Vertiefung 1 befindet, ist als Abdeckung eine Kunststoffschicht K aufgebracht.

In dem Ausführungsbeispiel nach Figur 2 ragen, im Gegensatz zu dem Ausführungsbeispiel nach Figur 1 die metallischen Kontakte 2 aus der tragbaren Datenträgeranordnung 0 heraus bzw. sind auf den Kunststoffkörper S aufgesetzt.

Figur 2a zeigt als Ausgangsprodukt eines erfindungsgemäßen Verfahrens einen Kunststoffkörper S mit einer flächigen Vertiefung 1 und mit Öffnungen 3 im Bereich dieser flächigen Vertiefung 1.

Figur 2b zeigt den Gegenstand von Figur 2a, nachdem ein Verfahrensschritt a nach Patentanspruch 1 durchgeführtworden ist. Demgemäß sind im Bereich der flächigen Vertiefung 1 metallische Anschlüsse 4 zu erkennen, die durch die Öffnungen 3 im Kunststoffkörper S durchkontaktiert und mit an der der flächigen Vertiefung 1 gegenüberliegenden Hauptoberfläche des Kunststoffkörpers S angeordneten metallischen Kontakten 2 verbunden sind.

Figur 2c zeigt den Gegenstand von Figur 2b, nachdem entsprechend dem gezeigten Ausführungsbeispiel mit Hilfe der Flip-Chip- Montagetechnik ein Verfahrensschritt b und ein Verfahrensschritt c gemäß den Patentansprüchen durchgeführt worden sind. Zusätzlich zu Figur 2b zeigt Figur 2c einen integrierten Schaltkreis 6 mit Anschlußpads P, die über Verbindungsmittel 11 sowohl elektrisch als auch mechanisch mit den metallischen Anschlüssen 4 verbunden sind.

Figur 2d zeigt den Gegenstand von Figur 2c, nachdem ein Verfahrensschritt d gemäß des Patentanspruches 1 durchgeführt worden ist und zwar der Gestalt, daß eine Kunststoffschicht K auf die Hauptoberfläche des Kunststoffkörpers S, an der sich die flächige Vertiefung 1 befindet, aufgebracht worden ist. Eine solche Kunststoffschicht kann entweder einen Teil oder die gesamte Hauptoberfläche des Kunststoffkörpers S abdecken. Die Abmessungen in den Figuren 2a bis 2e sind aufgrund der besseren Übersichtlichkeit nicht maßstäblich.

Figur 3a zeigt die Hauptoberfläche eines tragbaren flachen Kunststoffkörpers in Form einer Chipkarte mit eine flächigen Vertiefung 1, an der diese flächige Vertiefung 1 angeordnet ist. Innerhalb dieser flächigen Vertiefung 1 sind zwei metallische Induktivitäten 8 dargestellt, jeweils mit zwei metallischen Anschlüssen 4. Außerdem sind acht weitere metallische Anschlüsse 4 dargestellt, die zu auf der gegenüberliegenden Seite des flachen Kunststoffkörpers angeordneten, als verdeckte Kanten dargestellten metallischen Kontakten 2 durchkontaktiert sind. Die metallischen Anschlüsse 4 sind jeweils über einen Bonddraht 5 mit dem integrierten Schaltkreis 6 verbunden. Die in Figur 4a gezeigte Chipkarte weist einen für einen Magnetstreifen vorgesehenen Bereich 9 sowie einen für eine Prägung vorgesehenen Bereich 10 nach den für Chipkarten vorgesehenen ISO-Vereinbarungen auf.

Figur 3b zeigt die andere Hauptoberfläche des in Figur 2 in Form einer Chipkarte dargestellten tragbaren flachen Kunststoffkörpers 0. Auch hier ist durch strichpunktierte Linie jeweils ein Bereich 9 für einen Magnetstreifen und ein Bereich 10 für eine Prägung dargestellt. Außerdem sind acht flächige metallische Kontakte 2 gezeigt.

Die DE 39 35 364 C1 beschreibt den schaltungstechnischen Teil eines Ausführungsbeispieles einer Chipkarte, bei der die Energieversorgung und der bidirektionale Datenaustausch sowohl über Kontakte bewirkt werden kann, als auch über induktive Spulen.

Die Figuren 3a und 3b zeigen eine Ausführungsform eines tragbaren flachen Kunststoffkörpers in Form einer Chipkarte, bei der es aufgrund des gezielten Anbringens der flächigen Induktivitäten möglich ist, eine normgerechte Chipkarte mit Kontaktfeld, mit Prägezone und mit Magnetstreifen zu versehen, die außerdem in stationären Einheiten mit Energie- und Datenübertragung aufgrund elektromagnetischer Felder benutztwerden kann, falls in einer solchen stationären Einheit das oder die erregten elektromagnetischen Felaer in ausreichend großem Abstand zu dem Magnetstreifen der Chipkarte im Bereich der in der Chipkarte integrierten Induktivitäten vorgesehen sind und die magnetische Feldstärke dieser Felder in Abhängigkeit von ihrem Abstand zu dem Magnetstreifen bestimmte Grenzwerte nicht überschreiten.

In den Figuren nicht im Einzelnen dargestellt aber vom Fachmann nachvollziehbar isteine Ausführungsform einer tragbaren Datenträgeranordnung, die nach erfindungsgemäßen Verfahren hergestellt wird, wobei die Koppelelemente zum Übertragen elektromagnetischer Signale und zum Übertragen von Energie aus in einer Ebene realisierten flächigen metallischen Induktivitäten bestehen, die im Bereich einer flächigen Vertiefung unmittelbar auf den Kunststoffkörper aufgebracht sind, die nach Einbringen eines integrierten Schaltkreises in diese flächige Vertiefung mitAnschlußpads dieses Schaltkreises elektrisch leitend verbunden werden und die dann gemeinsam mit diesem integrierten Schaltkreis mit Kunststoff von außen unzugänglich abgedeckt werden. Eine solche Anordnung ist nach dem Patentanspruch 1 herstellbar. Figur 3a zeigt eine solche Chipkarte, wobei jedoch zusätzlich metallische Anschlüsse 4 für auf der gegenüberliegenden Seite vorgesehene Kontakte dargestellt sind.

## Patentansprüche

1. Verfahren zum Herstellen einer tragbaren Datentrageranordnung (0), bestehend aus einem flachen Kunststoffkörper (S) mit einer flächigen Vertiefung (1) an einer seiner Hauptoberflächen und mit Koppelelementen zur Energieversorgung und/oder zum Datenaustausch zwischen Datenträger und einem Schreib/Lesegerät in Form von flächigen metallischen Induktivitäten (8), die über metallische Anschlüsse (4) mit der integrierten Schaltung (6) elektrisch leitend verbindbar sind (5;11),
gekennzeichnet durch folgende Verfahrensschritte:
a) die flächigen metallischen Induktivitäten (8) und die metallischen Anschlüsse (4) werden innerhalb des Bereichs der flächigen Vertiefung (1) unmittelbar auf den Kunststoffkörper (3) aufgebracht;
b) die integrierte/n Schaltung/en (6) wird/werden unmittelbar in die flächige Vertiefung (1) des Kunstatoffkörpers (3) eingebracht;
c) die metallischen Induktivitäten (8) werden mit der/den integrierte/n Schaltung/en (6) elektrisch leitend verbunden;
d) die integrierte/n Schaltung/en (6) wird/werden mit Kunststoff (12) von außen unzugänglich abgedeckt.

2. Verfahren zur Herstellung einer tragbaren Datenträgeranordnung (0), bestehend aus einem flachen Kunststoffkörper (S) mit einer flächigen Vertiefung (1) an einer seiner Hauptoberflächen, mit Öffnungen (3) innerhalb des Bereichs derflächigen Vertiefung zur gegenüberliegenden Hauptoberfläche, mit mindestens einer integrierten Schaltung (6) in der flächigen Vertiefung (1), mit metallischen Anschlüssen (4) in der Vertiefung (1), mit Koppelelementen zur Energieversorgung und/oder zum Datenaustausch zwischen Datenträger und einem Schreib/Lesegerät in Form flächiger metallischer Kontakte (2), die mit der integrierten Schaltung (6) durch die Öffnungen (3) über die metallischen Anschlüsse (4) elektrisch leitend verbindbar sind (5; 11), und mit Koppelelementen zur Energieversorgung und/oder Datenaustausch zwischen Datenträger und Schreib/Lesegerät in Form flächiger Induktivitäten (8), die ebenfalls über Anschlüsse (4) mit der integrierten Schaltung (6) elektrisch leitend verbindbar sind (5; 11)
gekennzeichnet durch folgende Verfahrensschritte:
a) die flächigen metallischen Kontakte (2) werden an der der flächigen Vertiefung gegenüberliegenden Seite des Kunststoffkörpers unmittelbar auf den Kunststoffkärper aufgebracht, die metallischen Anschlüsse (4) und die Induktivitäten (8) werden im gleichen Arbeitsgang in der flächigen Vertiefung (1) auf den Kunststoffkörper aufgebracht und ebenfalls im gleichen Arbeitsgang wird als Durchkontaktierung eine Metallisierung (4) im Bereich der in dem Kunststoffkörper befindlichen Öffnungen (3) vorgenommen;
b) die integrierte/n Schaltung/en (6) wird/werden unmittelbar in die flächige Vertiefung (1) des Kunststoffkörpers eingebracht;
c) die metallischen Kontakte werden mit der/den integrierte/n Schaltung/en elektrisch leitend verbunden (5; 11);
d) die integrierte/n Schaltung/en (6) wird/werden mit Kunststoff (12; K) von außen unzugänglich abgedeckt.

3. Verfahren nach Anspruch 1 oder 2,
dadurch gekennzeichnet,
daß die flächigen metallischen Koppelelemente (8,2) und Anschlüsse (4) durch außenstromloses Abscheiden aufgebracht werden.

4. Verfahren nach Anspruch 1 oder 2,
dadurch gekennzeichnet,
daß die metallischen Koppelelemente (8) und Anschlüsse (4) durch Sputtern aufgebracht sind.

5. Verfahren nach einem der vorherigen Ansprüche,
dadurch gekennzeichnet,
daß die integrierte/n Schaltung/en (6) auf eine Oberfläche des Kunststoffkörpers geklebt wird/werden (7) und daß die metallischen Koppelelemente (8, 2) über die Anschlüsse (4) durch ein Drahtbondverfahren (5) mit dem/ den integrierten Schaltkreis/ en (6) elektrisch leitend verbunden werden.

6. Verfahren nach Anspruch 1, 2, 3 oder 4,
dadurch gekennzeichnet,
daß die integrierte Schaltung in Flip-Chip-Montagetechnik mit den entsprechend ausgestalteten metallischen Anschlüssen (4) elektrisch leitend verbunden wird.

7. Verfahren nach einem der vorherigen Ansprüche,
dadurch gekennzeichnet,
daß auf die integrierte/n Schaltung/en (6) ein viskoser Kunststoff (12) aufgetragen wird, daß dieser Kunststoff nach dem Auftragen ausgehärtet wird und somit die integrierte Schaltung von außen unzugänglich abdeckt.

8. Verfahren nach einem der vorherigen Ansprüche,
dadurch gekennzeichnet,
daß nach dem elektrisch leitenden Verbinden der metallischen Anschlüsse (4) mit der/den integrierte/n Schaltung/en (6) auf einer Oberfläche des Kunststoffkörpers (S) eine Kunststoffschicht (K) auflaminiert wird, die die integrierte/n Schaltung/en (6) von außen unzugänglich abdeckt.

9. Verfahren nach einem der Ansprüche 1 bis 7,
dadurch gekennzeichnet,
daß nach dem elektrisch leitenden Verbinden (5, 11) der metallischen Anschlüsse (4) mit der/den integrierte/n Schaltung/en (6) die flächige Vertiefung (1) mit einem paßgenauen Kunststoffteil (12) ausgefüllt wird und somit der/die integrierte/n Schaltung/en (6) abgedeckt wird/werden.

## Claims

1. Process for producing a portable data carriercon- figuration (O) comprising a flat plastic body (S) having a planar indentation (1) on one of its main surfaces and having coupling elements for energy supply and/or for data exchange between the data carrier and a read/write device in the form of planar metal inductances (8), which can be connected electrically conductively (5; 11) via metal terminals (4) to the integrated circuit (6), characterized by the following process steps:
a) the planar metal inductances (8) and the metal terminals (4) are applied directly on the plastic body (3) within the region of the planar indentation (1);
b) the integrated circuit/s (6) is/are introduced directly into the planar indentation (1) of the plastic body (3);
c) the metal inductances (8) are connected electrically conductively to the integrated circuit/s (6);
d) the integrated circuit/s (6) is/are covered inaccessibly from the outside with plastic (12).

2. Process for producing a portable data carrier configuration (O), comprising a flat plastic body (S) having a planar indentation (1) on one of its main surfaces, having openings (3) within the region of the planar indentation with respect to the opposite main surface, having at least one integrated circuit (6) in the planar indentation (1), having metal terminals (4) in the indentation (1), having coupling elements for energy supply and/or for data exchange between the data carrier and a read/write device in the form of planar metal contacts (2) which can be connected electrically conductively (5; 11) to the integrated circuit (6) through the openings (3) via the metal terminals (4), and having coupling elements for energy supply and/or data exchange between the data carrier and the read/write device in the form of planar inductances (8) which likewise can be connected electrically conductively (5; 11) via terminals (4) to the integrated circuit (6), characterized by the following process steps:
a) the planar metal contacts (2) are applied directly to the plastic body on the side of the plastic body opposite the planar indentation, the metal terminals (4) and the inductances (8) are applied in the same operation to the plastic body in the planar indentation (1) and, likewise in the same operation, a metallization (4) is performed as through plating in the region of the openings (3) located in the plastic body;
b) the integrated circuit/s (6) is/are introduced directly into the planar indentation (1) of the plastic body;
c) the metal contacts are connected electrically conductively (5; 11) to the integrated circuit/s;
d) the integrated circuit/s (6) is/are covered inaccessibly from the outside with plastic (12; K).

3. Process according to Claim 1 or 2, characterized in that the planar metal coupling elements (8, 2) and terminals (4) are applied by deposition without any external current.

4. Process according to Claim 1 or 2, characterized in that the metal coupling elements (8) and terminals (4) are applied by sputtering.

5. Process according to one of the preceding claims, characterized in that the integrated circuit/s (6) is/are adhesively attached (7) onto a surface of the plastic body and in that the metal coupling elements (8, 2) are connected electrically conductively via the terminals (4) to the integrated circuit/s (6) by a wire bonding process (5).

6. Process according to Claim 1, 2, 3 or 4, characterized in that the integrated circuit is connected electrically conductively to the correspondingly designed metal terminals (4) by the flip-chip mounting technique.

7. Process according to one of the preceding claims, characterized in that a viscous plastic (12) is applied to the integrated circuit/s (6), in that this plastic is cured after application and consequently covers the integrated circuit inaccessibly from the outside.

8. Process according to one of the preceding claims, characterized in that, after the electrically conductive connecting of the metal terminals (4) to the integrated circuit/s (6), on one surface of the plastic body (S) there is laminated a plastic layer (K), which covers the integrated circuit/s (6) inaccessibly from the outside.

9. Process according to one of Claims 1 to 7, characterized in that, after the electrically conductive connecting (5, 11) of the metal terminals (4) to the integrated circuit/s (6), the planar indentation (1) is filled with an accurately fitting plastic part (12) and consequently the integrated circuit/s (6) is/are covered.

## Revendications

1. Procédé pour fabriquer un dispositif portable (O) formant support de données, constitué par un corps plat en matière plastique (S) possédant un renfoncement d'une certaine étendue en surface (1) situé dans l'une des surfaces principales du corps en matière plastique, et comportant des éléments de couplage pour l'alimentation en énergie et/ou l'échange de données entre le support de données et un appareil d'écriture/lecture, sous la forme d'inductances métalliques d'une certaine étendue en surface (8), qui peuvent être reliées d'une manière électriquement conductrice (5; 11) au circuit intégré (6), caractérisé par les étapes opératoires suivantes :
a) on dépose les inductances métalliques (8) d'une certaine étendue en surface et les bandes métalliques (4) directement sur le corps en matière plastique (3), à l'intérieur de la zone du renfoncement d'une certaine étendue en surface (1);
b) on introduit le ou les circuits (6) directement dans le renfoncement d'une certaine étendue en surface (1) du corps en matière plastique (3);
c) on relie d'une manière électriquement conductrice les inductances métalliques (8) au(x) circuit(s) intégré(s) (6);
d) on recouvre extérieurement par une matière plastique (12) le ou les circuits intégrés (6) de manière qu'ils soient inaccessibles.

2. Procédé pour fabriquer un dispositif portable (0) formant support de données, constitué par un corps plat en matière plastique (S) possédant un renfoncement (1) d'une certaine étendue en surface, ménagé dans l'une de ses faces principales, comportant des ouvertures (3) situées à l'in- térieurde la zone du renfoncement d'une certaine étendue en surface et qui s'étendent jusqu'à la surface principale opposée, au moins un circuit intégré (6) situé dans le renfoncement (1) d'une certaine étendue en surface, des bornes métalliques (4) situées dans le renfoncement (1), des éléments d'accouplement pour l'alimentation en énergie et/ou pour l'échange de données entre le support de données et un appareil d'écriture/lec- ture sous la forme de contacts métalliques d'une certaine étendue en surface (2), qui peuvent être reliés d'une manière électriquement conductrice (5; 11) au circuit intégré (6) par les ouvertures (3) par l'intermédiaire des bornes métalliques (4), et comportant des éléments de couplage pour l'alimentation en énergie et/ou l'échange de données entre le support de données et l'appareil d'écriture/lecture sous la forme d'inductances d'une certaine étendue en surface (8), qui peuvent être également reliées d'une manière électriquement conductrice (5; 11), par l'intermédiaire de bornes (4), au circuit intégré (6), caractérisé par les étapes opératoires suivantes :
a) on dépose les contacts métalliques (2) d'une certaine étendue en surface directement sur le corps en matière plastique, au niveau de la face du corps en matière plastique, qui est située à l'opposé du renfoncement d'une certaine étendue en surface, on dépose les bandes métalliques (4) et les inductances (8) lors de la même étape opératoire, dans le renfoncement d'une certaine étendue en surface (1) dans le corps en matière plastique et on réalise également lors de la même étape opératoire, sous la forme de l'établissement d'un contact traversant, une métallisation (4) dans la zone des ouvertures (3) situées dans le corps en matière plastique;
b) on insère le ou les circuits intégrés (6) directement dans le renfoncement d'une certaine étendue en surface (1) du corps en matière plastique;
c) on relie d'une manière électriquement conductrice les contacts métalliques au(x) circuit(s) intégré(s);
d) on recouvre extérieurement par une matière plastique (12; K) le ou les circuits intégrés (6) de manière qu'ils soient inaccessibles.

3. Procédé suivant la revendication 1 ou 2, caractérisé par le fait qu'on dépose les composantes métalliques de couplage (8,2) d'une certaine étendue en surface et les bornes (4) au moyen d'un dépôt sans apport de courant extérieur.

4. Procédé suivant la revendication 1 ou 2, caractérisé par le fait qu'on dépose par pulvérisation cathodique les éléments de couplage métallique (8,2) et les bornes (4).

5. Procédé suivant l'une des revendications précédentes, caractérisé par le fait qu'on colle (7) le ou les circuits intégrés (6) sur une surface du corps en matière plastique et qu'on relie d'une manière électriquement conductrice les éléments de couplage métalliques (8,2) par l'intermédiaire des bornes (4) au moyen d'un procédé de fixation de fils (5), au(x) circuit(s) intégré(s) (6).

6. Procédé suivant la revendication 1, 2, 3 ou 4, caractérisé par le fait qu'on relie d'une manière électriquement conductrice le circuit intégré selon la technique de montage flip-chip aux bornes métalliques (4) agencées de façon correspondante.

7. Procédé suivant l'une des revendications précédentes, caractérisé par le fait qu'on dépose sur le ou les circuits intégrés (6) une matière plastique visqueuse (12) de telle sorte que cette matière plastique durcit après le dépôt et recouvre par conséquent extérieurement le circuit intégré de manière qu'il soit inaccessible.

8. Procédé suivant l'une des revendications précédentes, caractérisé par le fait qu'après la liaison électriquement conductrice des bornes métalliques (4) au(x) circuit(s) intégré(s), on applique sur une surface du corps en matière plastique (S) une couche de matière plastique (K) qui recouvre extérieurement le ou les circuits intégrés (6) de manière qu'ils soient inaccessibles.

9. Procédé suivant l'une des revendications 1 à 7, caractérisé par le fait qu'après la liaison électriquement conductrice (5,11) des bornes métalliques (4) au(x) circuit(s) intégré(s) (6), on remplit le renfoncement d'une certaine étendue en surface (1) avec une pièce en matière plastique (12) ajustée de façon précise et on recouvre par conséquent le ou les circuits intégrés (6).
